Europäisches Patentamt

European Patent Office

Office européen des brevets

(11) Publication number: **0 263 631**
**A2**

## (12) EUROPEAN PATENT APPLICATION

(21) Application number: 87308603.7

(22) Date of filing: 29.09.87

(51) Int. Cl.4: **H05K 7/08**

(30) Priority: **10.10.86 GB 8624374**

(43) Date of publication of application:
**13.04.88 Bulletin 88/15**

(84) Designated Contracting States:
**DE FR GB IT**

(71) Applicant: **EATON CONTROLS SpA**
**Via Edolo 26**
**I-20125 Milano(IT)**

(72) Inventor: **Riley, John Grant**
**35 Rue St Erhardt**
**F-67100 Strasbourg(FR)**
Inventor: **Doutriaux, Jean Luc**
**4 Rue de Chenonceaux**
**F-67000 Strasbourg(FR)**

(74) Representative: **Douglas, John Andrew**
**Eaton House Staines Road**
**Hounslow Middlesex TW4 5DX(GB)**

(54) · **Terminated electrical component and method.**

(57) The conductors (2) exiting from the housing of a component (1) may be grouped conveniently for one customer but inconveniently for others. Manufacturing components with different groupings for each customer would lose the advantages of quantity. So the exiting conductors (2) are connected to plated through-holes in an inner PCB (5). Fastons are connected to plated holes in an outer PCB (8) in a fashion approved by an individual customer. Bridging connectors which are rigid extend between bondings in opposite holes in the two PCB's. The printed patterns on the boards enable the change of grouping of the terminals. Some bridging connectors may be extensions (7) of the exiting conductors (4). They provide rigidity of the boards and also interconnections. The inner board (5) rests on walls (3) from the housing (1), or on ledges or flanges (13) of the connectors.

Fig.5.

## TERMINATED ELECTRICAL COMPONENT AND METHOD

The present invention relates to an electrically terminated component of the type having a group of stiff conductors exiting a casing or housing, eg over a surface or side thereof so that at least a group thereof point generally in the same direction but are grouped in an arbitrary but definite pattern. The invention also relates to a method of terminating a component.

Such components are often sold to several different customers, such as washing machine programmer-timer units which may be sold to many different domestic appliance manufacturers for incorporation in their products. A problem arises in that the different customers will prefer the components to be terminated not all in the same way, ie they will want the conductors disposed in different patterns or groupings, according to the electrical layouts of their respective products; any component manufacturer who attempts to meet this by individual design of the layout of exiting conductors will lose advantages of scale of production and have paperwork, bills of material, warehousing or other problems in planning production programmes and storing all the different versions of the same component.

In order to have all the components uniform, with rigid conductors issuing at the same points on the housing, the component supplier sometimes wires up an external adapter or socket and plug arrangement to regroup the conductors, but this solution is expensive in time, and bulk is added to the component. Flexible or flying leads on components are not usually desirable.

Accordingly, the present invention enables components to be manufactured uniformly with rigid exiting conductors but terminated in individual groupings, by use of attachment of a pair of stacked printed circuit boards (PCB's) each having conductive through holes participating in printed patterns, of rigid conductors bonded through said holes of both PCB's, and of extensions of said rigid exiting conductors bonded through said holes of at least the inner PCB, the inner PCB preferably resting flat against projecting portions of the component housing, and the holes of the outer PCB accommodating anchoring pins of external terminals. Different customers will then receive the same component and PCB's, but with one or both PCB's differently printed.

It is known from US-A-4 208 080 or 4 054 939 or 4 331 370 to stack PCB's with opposed through-holes and respective rigid conductors bonded through the holes, but the edges of the board are used for terminals and no suggestion of altered terminal patterns is taught.

Further features and advantages of the present invention will appear from the following description of embodiments thereof, given by way of example, in conjunction with the drawings, in which:-

Figure 1 shows a plan view of a component before the two inventive PCB termination boards have been attached;

Figure 2 shows on a smaller scale and in sectional side view the inventively terminated component;

Figure 3 shows a first rigid exit conductor;

Figure 4 shows a second rigid exit conductor;

Figure 5 shows a magnified detail of Figure 2;

Figures 6, 7 and 8 show PCB's in plan, illustrating printed circuits and conductive through-holes.

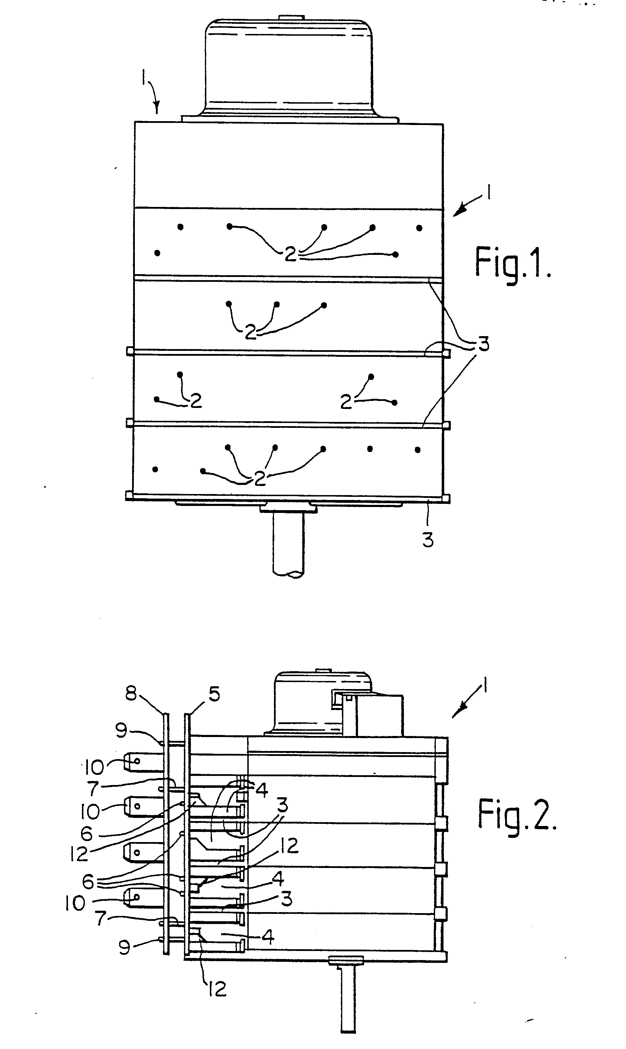

Referring to Figure 1, a component 1 such as an electro-mechanical programmer has exit conductor positions shown as dark dots 2 eg in four groups separated by thin insulating, conveniently parallel, partition walls 3. The walls are seen edge-on in Figure 1 and form insulating projections from the casing of the component walls and the conductors extend directly towards the viewer in Figure 1, ie all in the same direction. The conductors may be for programmed supplies to motors, heaters, water valves, pumps or other units in domestic apparatus. Two customers may like the component 1 but one may not select it from the manufacturer because of undesirable groupings of the conductor positions 2. It is highly inconvenient to manufacture different versions of the component having conductors at different positions 2. The invention enables one version to be terminated in very many different ways, so that most if not all customers can be suited without undue expense.

Referring to the side view of Figure 2, four conductors 4 can be seen and will occupy four of the positions 2 of Figure 1. Others will occupy different planes and be non-represented or invisible in Figure 2. A first, inner PCB 5 rests against the edges of the walls 3 which define a surface, and elongations 6, 7 of the conductors 4 pass through holes of a first set of conductive through-holes in PCB 5. Relatively shorter elongations 6 extend only a short distance out beyond inner PCB 5, while other conductors 4 have relatively longer elongations 7 which extend further out, and pass also through aligned holes of a second set of through-holes in a second, outer PCB 8 stacked parallel to the inner PCB. Some, or all of the two sets of through-holes may form aligned pairs which can accommodate such elongations 7.

The elongations are bonded eg by soldering to the through-holes passed through, so that the PCB's are located relative to the component 1. The inner PCB 5 is as aforesaid further supported by resting on the edges of walls 3. In addition, short conductive pins or pegs 9 extend just through both PCB's at aligned holes therein, being likewise soldered thereto. The short pins 9 perform at least a structural function, in holding and bracing the outer PCB to the inner one. At least some, indeed possibly all of the soldered pins and elongations 6, 7 and 9 may also function electrically with the printed conductors on the boards as will become apparent. In Figure 2 the actual depths as viewed of conductors 4 and the elongations and pins cannot be ascertained since they are grouped in various planes.

Also soldered to through-holes in outer PCB 8 are fastons 10 or other male connectors, which are also grouped in various planes, according to desirability or requirement of a customer. Printed tracks on boards 5, 8 will determine not only which faston connectors 10 are connected to which component conductors 4 according to the principal object of the invention; but also, by an option, interconnections between the fastons can be selectively made. Thus a customer's requirement can be served, which prior to this invention would have had to be met by the customer. Facility to save work normally accepted by the customer as his, as well as elegantly adapting the exit conductor groupings of the component 1 to the female groupings within one or multiple sockets of the customer, is a bonus of the invention. Further electrical and structural details, including alternative groupings of the conductive through-holes themselves, will readily occur to the worker but preferred examples are illustrated hereinafter. Meanwhile it is pointed out that the automatic wiring and management of wiring harnesses, which are in these cost-conscious days a virtual necessity at domestic and other machine manufacturers, involve great difficulties if wires require to be crossed over by the automated production gear between a position in the machine and the housing exit of the component 1. The invention avoids the purchaser having to cross-over wiring and gives him the bonus of having extra interconnections tailored by the component supplier, as aforesaid.

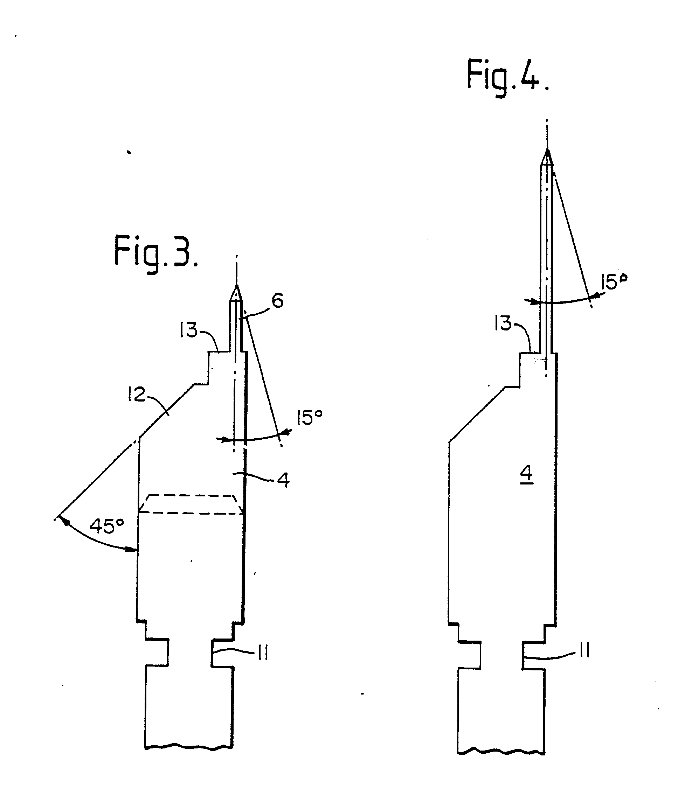

It will normally be expected to have printed circuitry on both surfaces of the outer PCB, but on the outer face only of the inner PCB; this is not a limitation of the invention, however, and all four surfaces or only one could carry inter-connecting tracks (or even a discrete component, if appropriate). It is also preferred but not essential for the inner PCB 5 to rest on walls 3 or other planar projections from the housing, but one or both PCB's can alternatively rest on shoulders formed as illustrated on the conductors 4. Referring to Figure 3, a conductor 4 conveniently is flat, has a waist 11 where it passes through the housing, is tapered at 12 to a support shoulder 13 and then terminates in a short elongation 6, or, see Figure 4, in a long pin-like elongation 7. If pins 9 are used, they can resemble the elongations 7, being pointed at one or both ends for ease in assembling in the through-holes. The preferred materials for the conductors, pins, elongations etc are copper and its alloys. The support shoulder 13 provides structural support additional to that provided by the soldered joint at the through hole, and additional or alternative to that of the projections 3.

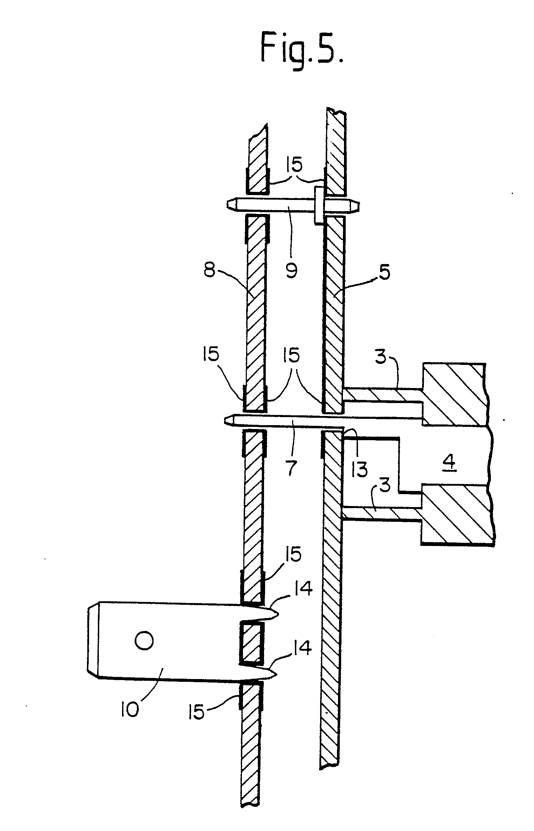

Figure 5 shows more visibly details of Figure 2, namely housing projecting walls 3, a rigid exiting conductor 4, PCB supporting shoulder 13, PCB's 5 and 8, a relatively longer elongation 7 and a pin 9 (soldered) in aligned through-holes, and a faston 10 having two mounting pins 14 soldered in further conductive through-holes in the outer PCB 8.

The forces involved in coupling to the multiple fastons are absorbed by board 8, braced as it is by the through pins 7 and 9, but one or more foam or honeycomb grid plastics spacers (not shown) may, eg under pressure from a side-clip, be sandwiched between the two PCB's to strengthen the structure and distribute mechanical loads or shocks, which might otherwise crack the soldering in the through-holes.

If desired, a support shoulder (none shown) can also be provided near the outer ends of the longer elongations 7, or of the pins 9, for the outer PCB to rest on. The through holes in the two PCB's will then need to be of different sizes or diameters, because the shoulders of elongations 7 will have to be passed through the holes of the inner PCB before abutting the outer PCB.

Figure 5 also shows that, as conventional, the plating of the through-holes extends at the flat portions at 15 on one or both sides of the two PCB's, for their inclusion in the printed circuitry on the one or both sides required.

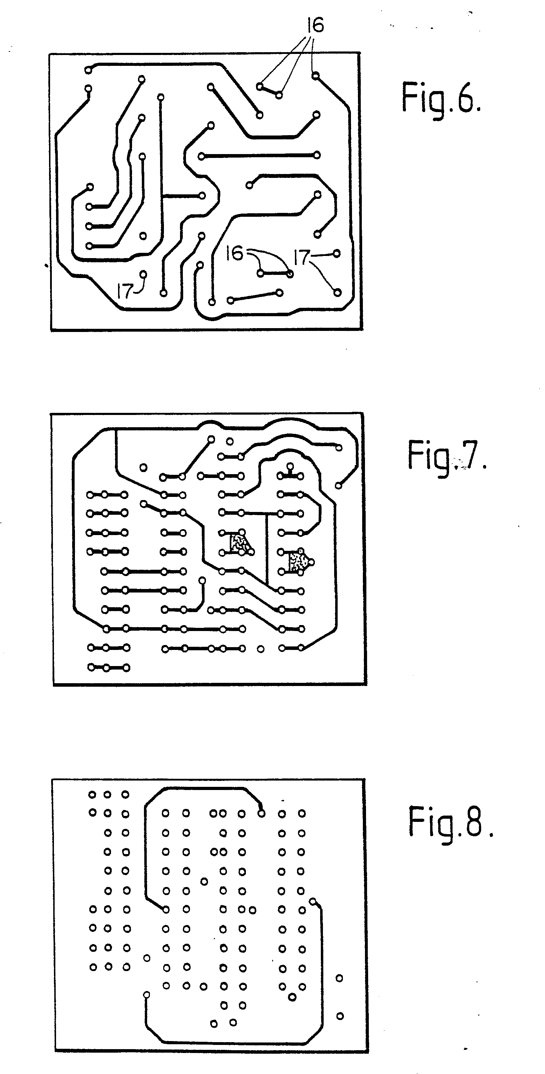

As already stated, one or both PCB's may have no printed circuitry on the eg inner side, accordingly this embodiment has inner PCB 5 with the pattern shown on Figure 6 on its outer side only. All the through holes 16, which it will be recalled are in four groups separated by the lines of abutment of the inner side with walls 3, are involved in the pattern. Some of the through-hole positions will correspond exactly with those of the rigid exit conductors 4, and others 17 are used for pins 9 which are not necessarily in circuit, but the pattern could vary from customer to customer because it cooperates with the outer PCB circuitry, which of course usually will also vary from customer to customer.

The outer PCB circuitry in one example is as shown in Figure 7 on the inner side and in Figure 8 on the outer side. The through-holes may be unused structurally or electrically, or accommodate pins 9, long elongations 7 or (in pairs) fastons 10. When the holes are electrically used, the inner or outer or both patterns may include them.

Designing the circuitry involves often a computer optimization, ie for minimum complications, crossovers, undue lengths, undue thicknesses in combination with length, and tracks at different voltages or at different power phases etc being closer than 3mm etc. Official authorities or manufacturers themselves set standards on preventing excessive temperature rises, voltage gradients etc in the hostile environments of the kitchen etc. Thick tracks take expensive time to deposit and it may be preferred to deposit two thinner tracks in shunt, eg using free space on the inner face of the inner PCB 5, for a shunting track.

Sometimes, the customer manufacturer may have one group of say five female connectors in one socket body, participating in a harness (without cross-overs as has been discussed herein), but he would be quite happy to select plugging in with either of the two rotations of this body, relative to all the other sockets from the harness. This allows more freedom in the detailed circuit design of the inventive PCB's because the corresponding five males or fastons can be connected in circuit in one of two ways, either in one order or its reverse. Such considerations are routine to modern planar circuit designers and their computer aids. Sometimes printing of heater feeds is a problem, eg up to 15-16 amps, for which accepted standards call for conductors 0,7 sq mm in cross-section. Some appliance manufacturers are happy to incorporate a relay, at least for the heater feed, so that the PCB need only cater for the relay drive current. The motor current for spin-drying is usually the next most severe consideration, ie location of these preferably shortest, and necessarily thickest tracks can take first priority at the design stage.

Therefore, there may be printed circuits on the PCB's designed (eg computer aided) having regard to local electrical and/or environmental standards, to customer requirements (eg non-crossover wiring runs), and possible freedom as to the one or or the reverse order of consecutive groups of said plug conductors.

## Claims

1. An electrically terminated component comprising rigid exit conductors (4) passing through a housing thereof at certain positions thereon, an inner PCB (5) resting against an abutment (3 and/or 13) positionally firm relative to the housing, said rigid exit conductors extending through and being conductively bonded to some of a first set of conductive through-holes (2) in the inner PCB, a printed pattern on the outer or both faces of the inner PCB (5) joining said some conductive through-holes to others of said set, an outer PCB (8) having a second set of conductive through-holes in a regular pattern therein, rigid inter-board conductors, each individual one of which may or may not (ie zero, some or all) be extensions (7) of said rigid exit conductors and each one of which is conductively bonded to respective ones of said first and second set of conductive through-holes. and hence locate the outer PCB (8), a printed pattern on one or both sides of the second PCB joining at least some of the conductive through-holes to others of said second set, and a group of plug conductors each having elongations (14) passing through and conductively bonded to ones of said second set of conductive through-holes; whereby

the grouping of said plug conductors (10) is in general unrelated to said certain positions of said rigid exit conductors on said component housing.

2. An electrically terminated component according to claim 1, characterized by support shoulders (13) on the rigid exiting conductors with one or both PCB's resting thereupon.

3. An electrically terminated component according to claim 1, characterized by spaced insulating walls (3) projecting from the housing of the component, the edges of which have the inner PCB resting thereupon.

4. An electrically terminated component according to claims 1, 2 or 3, characterized in that some of said second set of holes are conductively bonded together to give extra interconnections.

5. An electrically terminated component according to claim 2, characterized in that the conductors (4) have a waist (11) and/or a taper (12) to said support shoulder (13).

6. An electrically terminated component according to any of claims 1 to 5, characterized in that some of said rigid interboard conductors (9) only extend between the PCB's have pointed ends, and of these; all, some or none may be included in electrical circuitry.

7. Method of terminating an electrical component having rigid conductors (4) exiting in a given general direction, comprising attaching standard conductors (10) thereto, characterized by the following steps in any practical order, namely, providing a first PCB with first sets of conductive through-holes and printed circuitry connecting at least some of said through-holes, bonding the rigid conductors (4) to respective through-holes of the first set, providing a second PCB with a second set of conductive through-holes and printed circuitry connecting at least some of the latter through-holes, bonding said standard conductors (10) to some of the connected ones of the latter through holes, opposing the two PCB's, and bonding rigid bridging conductors (9, 7) to opposed through-holes of the two PCB's; whereby

the pattern or layout of the standard conductors differs from that of the exiting conductors, and

the first PCB rests against abutments (7 or 13) which are rigid with the component.

8. A method according to claim 7, characterized in that at least some (7) of the bridging conductors are extensions of the rigid exiting conductors (4).

9. A method according to claim 7 or 8, characterized in that plural components having similar exiting conductor patterns or layouts are terminated, the arrangement of printed conductors of the PCB's and of the bridging conductors being such that the standard connectors are arranged in different patterns or layouts.

10. A method according to claims 7, 8 or 9, characterized in that at the design stage, the highest current-carrying, ie thickest printed conductors are given priority.

Fig.1.

Fig.2.

# Fig.4.

# Fig.3.

# Fig.5.

0 263 631

Fig.6.

Fig.7.

Fig.8.